# EUROPEAN PATENT SPECIFICATION

(11) **EP 3 157 167 B1**
(45) Date of publication and mention of the grant of the patent: **30.12.2020**
(21) Application number: 16190134.3
(22) Date of filing: 22.09.2016
(51) Int. Cl.: H03B 5/12

(54) **LC-TANK OSCILLATOR HAVING INTRINSIC LOW-PASS FILTER**
LC-TANK-OSZILLATOR MIT INTRINSISCHEM TIEFPASSFILTER
OSCILLATEUR DE TANK LC AVEC FILTRE PASSE-BAS INTRINSÈQUE

(30) Priority: 14.10.2015 US 201562241723 P; 11.09.2016 US 201615262003
(43) Date of publication of application: 19.04.2017
(73) Proprietor: MEDIATEK INC., Hsin-Chu 300 (TW)
(72) Inventor: CHIU, Wei-Hao, Hsinchu City 30078 (TW); CHUEH, Tzu-Chan, Zhubei City, Hsinchu County 302 (TW); LIN, Ang-Sheng, Hsinchu City 30078 (TW)
(74) Representative: Hoefer & Partner Patentanwälte mbB

(56) References cited:
- US-A1- 2004 150 485
- US-A1- 2005 168 296
- US-A1- 2012 001 699

## Description

### Background

Recently, a low supply voltage has been a major solution for low-power system. However, for a digitally controlled oscillator (DCO) or a voltage-controlled oscillator (VCO), the low supply voltage results in a small swing of an oscillation signal, and a signal-to-noise ratio (SNR) will be worse accordingly. To solve the small swing and worse SNR problem, one solution is using a PMOS-only VCO or an NMOS-only VCO to double the swing, however, the PMOS-only VCO or NMOS-only VCO has high power consumption, and the high swing signal may destroy the transistors manufactured by advanced process.

In addition, another solution is to increase a current to maintain the power of the signal, however, as the current is increased, the inductance must be decreased, and the capacitance needs to be increased accordingly, hence causing some side effect. For example, if the supply voltage changes from 1.6V to 0.8V, the inductance must be 0.25x (i.e. 0.25 times the original inductance), the capacitance needs to increase by 4x. However, the small inductance may seriously degrade its quality factor (Q), and the VCO/DCO needs more power to compensate the performance. In addition, if parallel inductors are designed and the transconductance pair (gm-pair) feeds to a low impedance node to overcome the low quality factor issue, the VCO/DCO also has a parasitic oscillation issue.

US2005/0168296A1 discloses an oscillator according to the preamble portion of claim 1. US2012/0001699A1 and US2004/0150485A1 are disclosing oscillators with a symmetric structure.

### Summary

It is therefore an objective of the present invention to provide a VCO/DCO, which has a low supply voltage, and is capable of generating high swing oscillation signal without destroying the transistors, to solve the above-mentioned problems.

This is achieved by the oscillator of the present invention according to claim 1. The dependent claims pertain to corresponding further developments and improvements.

As will be seen more clearly from the detailed description following below, an oscillator for generating oscillation signals at two output terminals comprises an inductor coupled between the two output terminals, a capacitor coupled between the two output terminals, two P-type transistors and two N-type transistors. Source electrodes of the two P-type transistors are coupled to a supply voltage, and gate electrodes of the two P-type transistors are coupled to the two output terminals, respectively. Source electrodes of the two N-type transistors are coupled to a supply voltage, gate electrodes of the two N-type transistors are coupled to the two output terminals, respectively, and drain electrodes of the two N-type transistors are coupled to drain electrodes of the two P-type transistors, respectively. In addition, the drain electrodes of the two N-type transistors are coupled to two internal nodes of the inductor.

As will be seen more clearly from the detailed description following below, an oscillator for generating oscillation signals at two output terminals comprises two P-type transistors, two N-type transistors and a low-pass filter. Source electrodes of the two P-type transistors are coupled to a supply voltage, and gate electrodes of the two P-type transistors are coupled to the two output terminals, respectively. Source electrodes of the two N-type transistors are coupled to a supply voltage, gate electrodes of the two N-type transistors are coupled to the two output terminals, respectively, and drain electrodes of the two N-type transistors are coupled to drain electrodes of the two P-type transistors, respectively. In addition, the low-pass filter is coupled to the two P-type transistors and the two N-type transistors, and is arranged for filtering a frequency component of the oscillation signals generated according to a first inductor and a parasitic capacitance.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a concept of a signal model of a VCO/DCO according to one embodiment of the present invention.
FIG. 2 is a diagram illustrating an oscillator according to one embodiment of the present invention.
FIG. 3 shows the inductor and the connections according to one embodiment of the present invention.
FIG. 4 is an equivalent model of the oscillator according to one embodiment of the present invention.
FIG. 5 shows two auxiliary capacitors and the inductor according to one embodiment of the present invention.
FIG. 6 is an equivalent model of the oscillator according to another embodiment of the present invention.
FIG. 7 is a diagram illustrating an oscillator according to another embodiment of the present invention.
FIG. 8 is a diagram illustrating the oscillator shown in FIG. 7 when the oscillator operates in the high current mode according to one embodiment of the present invention.
FIG. 9 is a diagram illustrating the oscillator shown in FIG. 7 when the oscillator operates in the low current mode according to one embodiment of the present invention.
FIG. 10 is a diagram illustrating the oscillator when the oscillator operates in the high current mode according to another embodiment of the present invention.
FIG. 11 is a diagram illustrating the oscillator when the oscillator operates in the low current mode according to another embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ..." The terms "couple" and "couples" are intended to mean either an indirect or a direct electrical connection. Thus, if a first device couples to a second device, that connection may be through a direct electrical connection, or through an indirect electrical connection via other devices and connections.

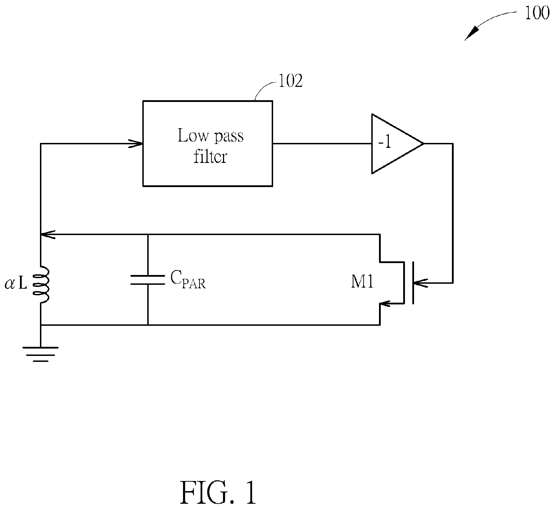

Please refer to FIG. 1, which is a diagram illustrating a concept of a signal model of an oscillator 100 according to one embodiment of the present invention. In this embodiment, the oscillator 100 is a VCO or a DCO. As shown in FIG. 1, because the oscillator 100 has a parasitic capacitance C_{PAR} and the parasitic capacitance C_{PAR} and a portion of inductor α^{∗}L may generate an unwanted high frequency component, the oscillator 100 designs a low-pass filter 102 (e.g. RC filter or LC filter) to filter this unwanted high frequency component. The transistor M1 shown in FIG. 1 is one of a NMOS pair in the oscillator 100.

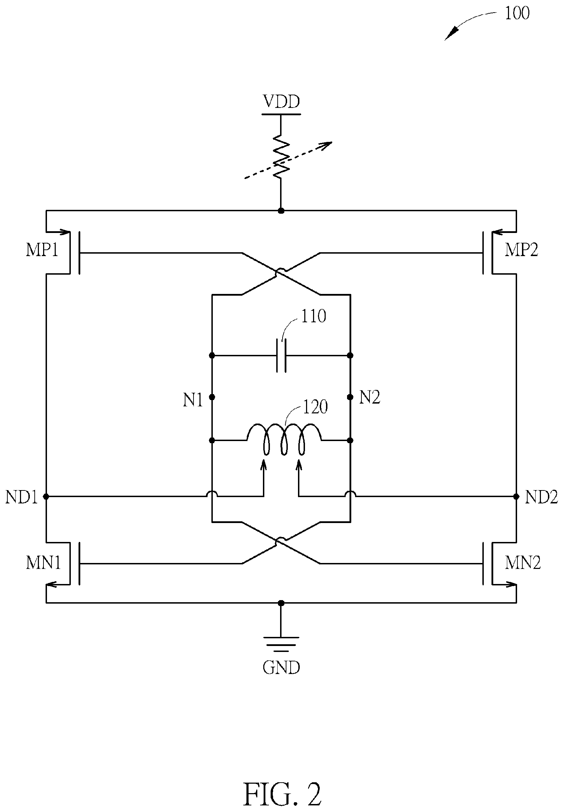

Please refer to FIG. 2, which is a diagram illustrating an exemplary embodiment of the oscillator 100 with reference to Fig. 1. As shown in FIG. 2, the oscillator 100 comprises a capacitor 110, an inductor 120, two PMOSs MP1 and MP2, and two NMOSs MN1 and MN2. In this embodiment, the inductor 120 and the capacitor 110 are connected in parallel to form an oscillation circuit; the PMOSs MP1 and MP2 are coupled to a supply voltage VDD, and gate electrodes of the PMOSs MP1 and MP2 are coupled to two output terminals N2 and N1, respectively; the NMOSs MN1 and MN2 are coupled to a ground voltage GND, gate electrodes of the NMOSs MN1 and MN2 are coupled to the output terminals N2 and N1, respectively, and drain electrodes (ND1 and ND2) of the NMOSs MN1 and MN2 are coupled to drain electrodes of the NMOSs MN1 and MN2, respectively. In addition, the drain electrodes ND1 and ND2 of the NMOSs MN1 and MN2 are coupled to two internal nodes of the inductor 120.

In this embodiment, the oscillator 100 is a LC-tank DCO or VCO, the capacitor 110 may be implemented by a switch capacitor array, and an internal node of the capacitor 110 may serve as an input terminal of the oscillator 100; and the oscillator 100 may receive a control voltage at the input terminal to generate oscillation signals at the output terminals N1 and N2.

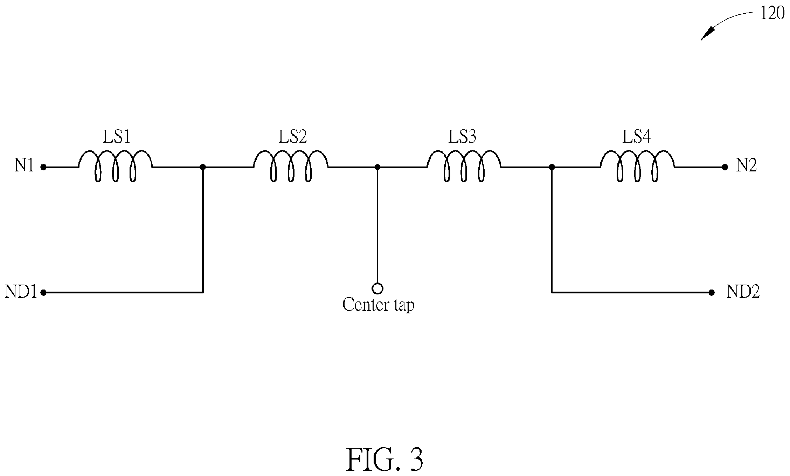

FIG. 3 shows the inductor 120 and the connections according to one embodiment of the present invention. As shown in FIG. 3, the inductor 120 comprises a plurality of segments LS1-LS4, the drain electrode ND1 of the NMOS MN1 is connected to an internal node between the segments LS1 and LS2, the drain electrode ND2 of the NMOS MN2 is connected to an internal node between the segments LS3 and LS4, and an internal node between the segments LS2 and LS3 is connected to a center tap to receive a DC voltage. In this embodiment, the inductor 120 can by any type of integrated inductor such as an 8-shape inductor.

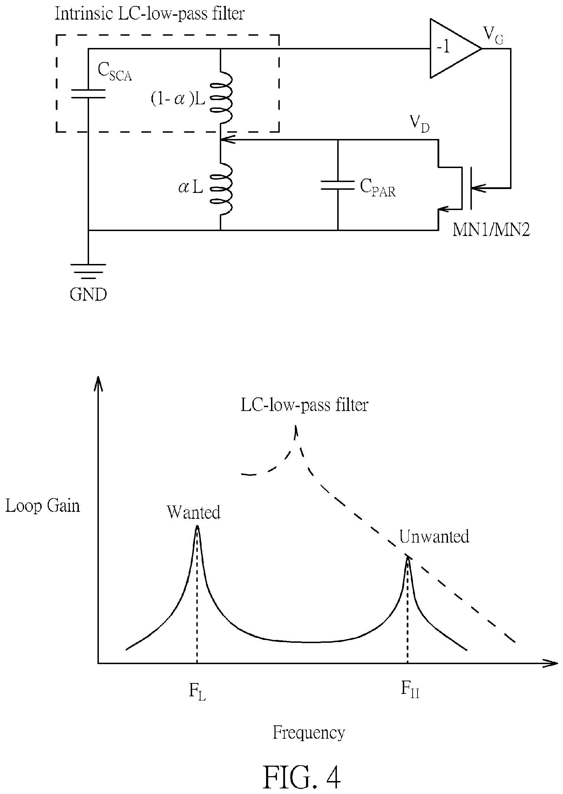

Please refer to FIG. 4, which is an equivalent model of the oscillator 100 shown in FIG. 3 according to one embodiment of the present invention, where the equivalent model shown in FIG. 4 is also an embodiment of the oscillator 100 shown in FIG. 1. As shown in FIG. 4, because the drain electrode ND1/ND2 of the NMOS MN1/MN2 is connected to the internal node of the inductor 120, the equivalent inductance of the inductor 120 for a capacitance C_{SCA} of the capacitor 110 is (α^{∗}L+(1-α)^{∗}L), and the equivalent inductance of the inductor 120 for a parasitic capacitance C_{PAR} is (α^{∗}L // (1-α)^{∗}L). In addition, because of the parasitic capacitance C_{PAR} shown in FIG. 4, the oscillation signals may have an unwanted frequency component generated by the parasitic capacitance C_{PAR} and the inductance α^{∗}L of a portion of the inductor 120. In other words, the oscillation signals may have two main frequency components, one is the desired frequency component) ${F}_{L} = \frac{1}{\sqrt{L ∗ {C}_{SCA}}} ,$ and the other one is the unwanted high frequency component ${F}_{H} = \frac{1}{\sqrt{\left(α∗L//\left(1-α\right)∗L\right) ∗ {C}_{PAR}}} .$ In this embodiment, the capacitance C_{SCA} of the capacitor 110 and the inductance (1-α)^{∗}L of a portion of the inductor 120 form an intrinsic LC-low-pass filter to lower the loop gain of the unwanted high frequency component F_{H}.

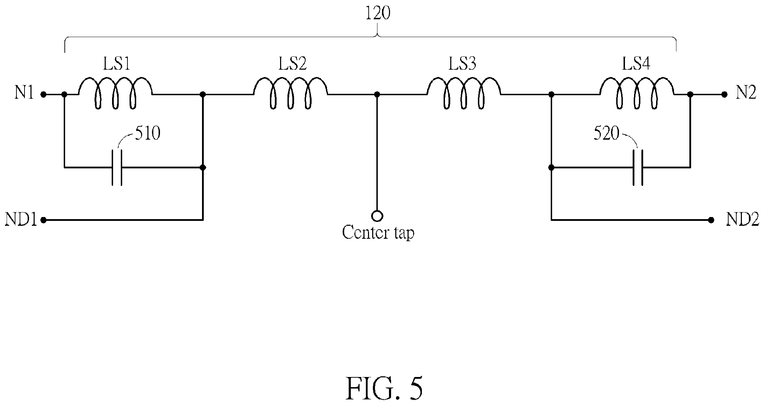

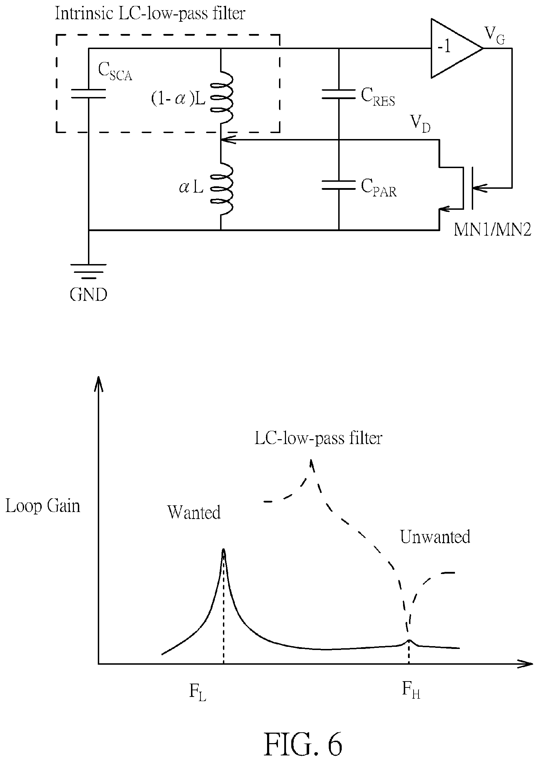

In another embodiment, the oscillator 100 can be modified to add two auxiliary capacitors to lower the loop gain of the unwanted high frequency component F_{H} more. Please refer to FIG. 5, which shows two auxiliary capacitors 510 and 520 and the inductor 120 according to one embodiment of the present invention. As shown in FIG. 5, the auxiliary capacitor 510 is coupled between the output terminal N1 and the drain electrode ND1 of the NMOS MN1, that is the auxiliary capacitor 510 is connected in parallel with the segment LS1 of the inductor 120; and the auxiliary capacitor 520 is coupled between the output terminal N2 and the drain electrode ND2 of the NMOS MN2, that is the auxiliary capacitor 520 is connected in parallel with the segment LS4 of the inductor 120. Referring to FIG. 6, the auxiliary capacitors 510 and 520 further make the intrinsic LC-low-pass filter to have a notch at the unwanted high frequency component F_{H}, thereby the loop gain of the unwanted high frequency component F_{H} can be lowered more.

In one embodiment, capacitances of the auxiliary capacitors 510 and 520 can be designed to satisfy an equation: α^{∗}L^{∗}C_{PAR}=(1-α)^{∗}L^{∗}C_{RES}, where C_{RES} is the capacitance of the auxiliary capacitor 510 or 520.

In addition, in the oscillator 100, because the inductor 120 shown in FIG. 3 can perform as a voltage divider, and the drain electrodes ND1/ND2 of the NMOSs MN1 and MN2 are connected to the internal nodes of the inductor 120, and the gate electrode of the of the NMOSs MN1 and MN2 are connected to the output terminals N2 and N1, the swing of the drain voltages VD of the NMOSs MN1 and MN2 may be close to the supply voltage VDD, and the swing of the gate voltages V_{G} of the NMOSs MN1 and MN2 will be larger than the swing of the drain voltages V_{D}. For example, if α=0.5 and the supply voltage VDD=0.9V, the maximum drain voltage V_{D} may be close to 0.9V, and the maximum gate voltage V_{G} may be close to 1.8V that is much greater than the supply voltage VDD. In light of the above mentioned, the lower drain voltage V_{D} can prevent the NMOSs MN1 /MN2 and the PMOSs MP1 /MP2 from being destroyed, and the high swing gate voltage V_{G} (i.e. high swing oscillation signals) can increase the SNR of the oscillation signals.

In addition, because the gate voltage V_{G} of the NMOS MN1 /MN2 has the large swing, a gate-source voltage (Vgs) will be larger to increase the current. Therefore, under a condition that the performance may satisfy a criteria, the transistor size can be decreased to lower the parasitic capacitance.

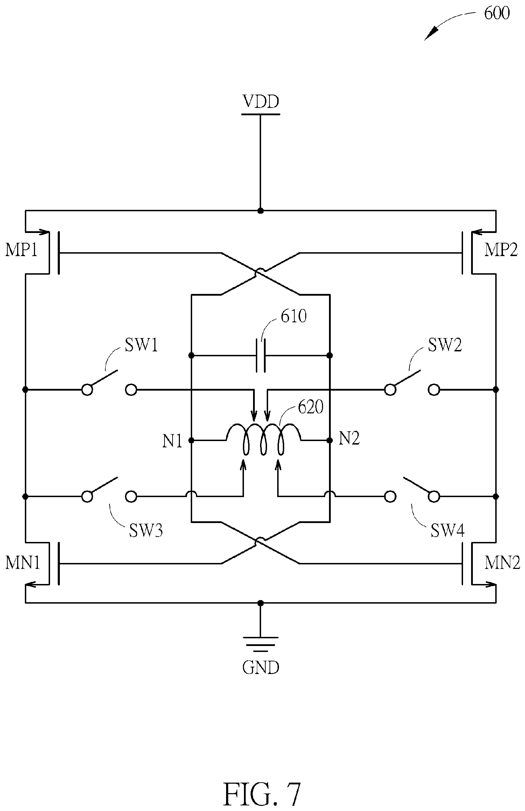

In the above-mentioned embodiment, the inductances of the segments LS1-LS4 of the inductor 120 are predetermined, that is, the "α" value cannot be adjusted. In another embodiment, however, the oscillator may be designed to select different "α" value. In detail, please refer to FIG. 7, which is a diagram illustrating an oscillator 600 according to one embodiment of the present invention. As shown in FIG. 7, the oscillator 600 comprises a capacitor 610, an inductor 620, two PMOSs MP1 and MP2, two NMOSs MN1 and MN2, and a switch module comprising a plurality of switches SW1-SW4. In this embodiment, the inductor 620 and the capacitor 610 are connected in parallel to form an oscillation circuit; the PMOSs MP1 and MP2 are coupled to a supply voltage VDD, and gate electrodes of the PMOSs MP1 and MP2 are coupled to two output terminals N2 and N1, respectively; the NMOSs MN1 and MN2 are coupled to a ground voltage GND, gate electrodes of the NMOSs MN1 and MN2 are coupled to the output terminals N2 and N1, respectively, and drain electrodes of the NMOSs MN1 and MN2 are coupled to drain electrodes of the NMOSs MN1 and MN2, respectively. In addition, the switch SW1 is arranged to selectively connect the drain electrode of the NMOS MN1 to a first internal node of the inductor 620; the switch SW2 is arranged to selectively connect the drain electrode of the NMOS MN2 to a second internal node of the inductor 620; the switch SW3 is arranged to selectively connect the drain electrode of the NMOS MN1 to a third internal node of the inductor 620; and the switch SW4 is arranged to selectively connect the drain electrode of the NMOS MN2 to a fourth internal node of the inductor 620.

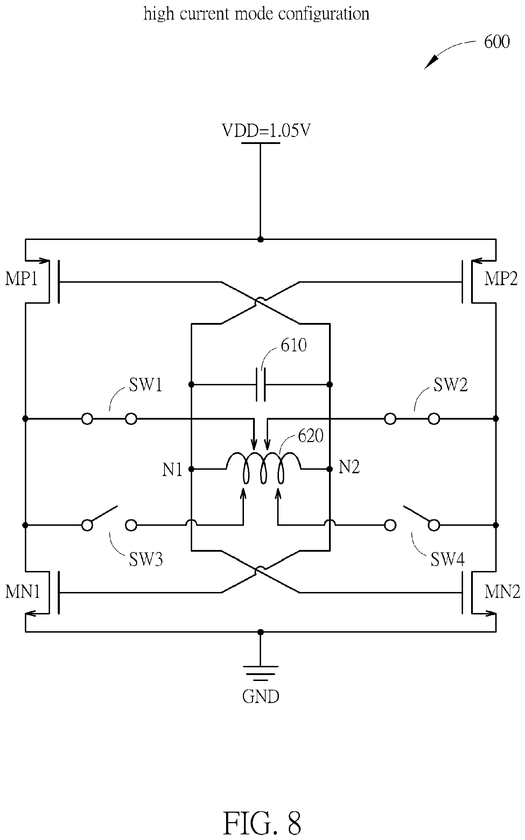

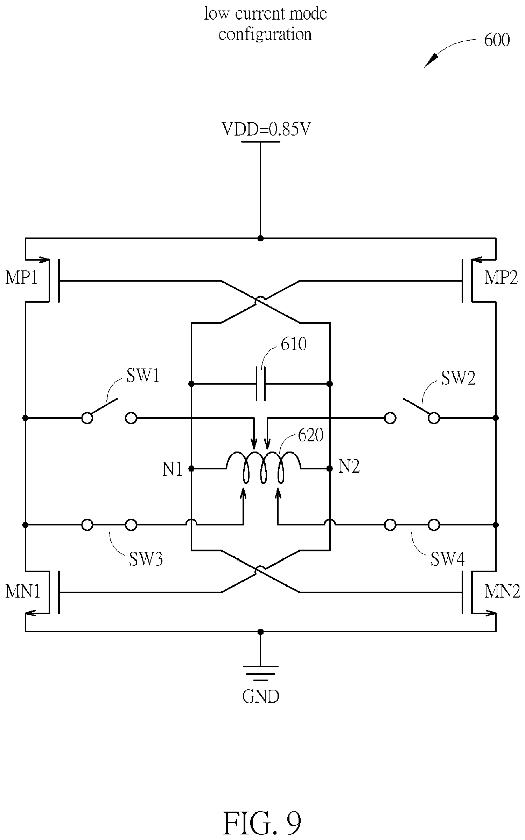

By turning on or turning off the switches SW1 -SW4, the inductor 620 may be divided to have different portions with different inductances, that is the "α" value of the equivalent model shown in FIG. 4 can be selected. By selecting the "α" value, the characteristics of the oscillator 600, such as the swing of the oscillation signals, may be changed. For example, in FIG. 8, when the oscillator 600 operates in a high current mode (e.g. 2G mode), the oscillator 600 may have the higher supply voltage VDD (e.g. 1.05V), the switches SW1 and SW2 are turned on while the switches SW3 and SW4 are turned off to make the inductor 120 to have a first "α" value. In addition, in FIG. 9, when the oscillator 600 operates in a low current mode (e.g. Long Term Evolution (LTE) mode), the oscillator 600 may have the lower supply voltage VDD (e.g. 0.85V), the switches SW1 and SW2 are turned off while the switches SW3 and SW4 are turned on to make the inductor 120 to have a second "α" value.

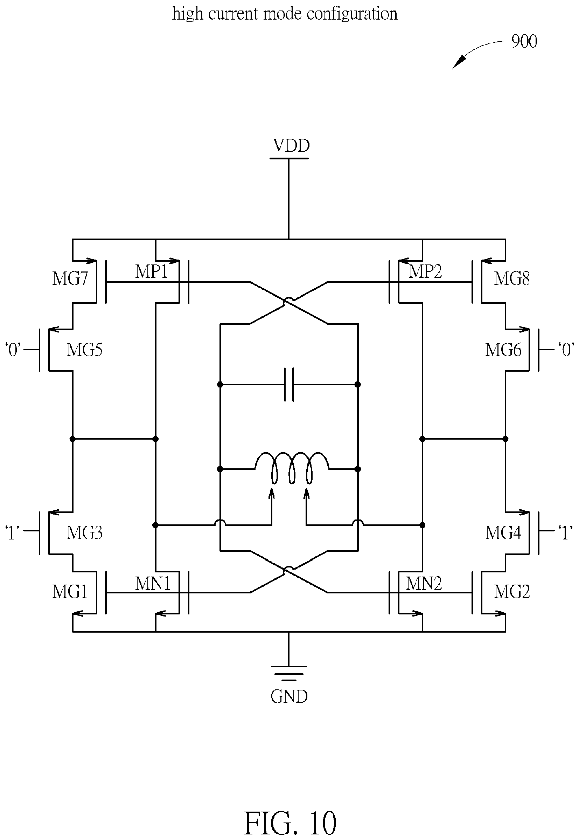

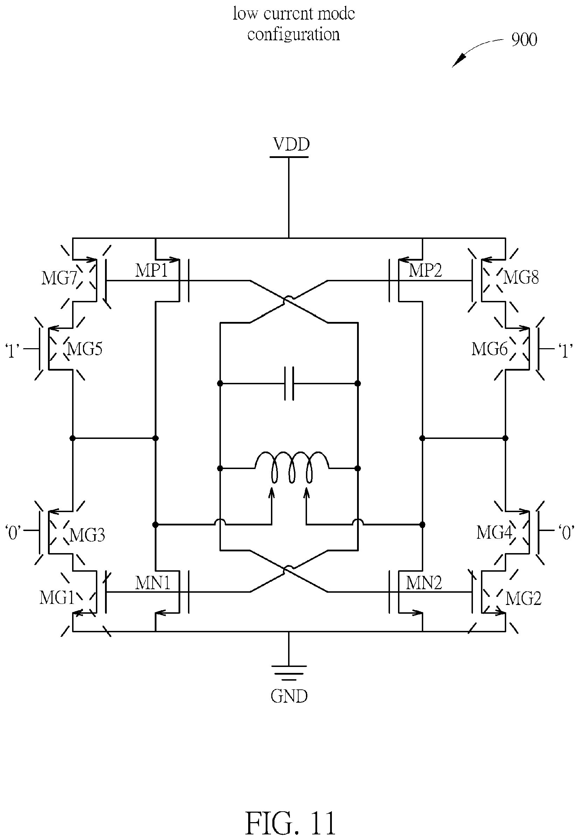

Please refer to FIG. 10 and FIG. 11, which are diagrams illustrating an oscillator 900 according to one embodiment of the present invention when the oscillator 900 operates in the high current mode (e.g. 2G mode) and the low current mode (e.g. LTE mode). As shown in FIG. 10, compared with the oscillator 100 shown in FIG. 1, the oscillator 900 further at least comprises a plurality of gating transistors MG1-MG8 to provide a tunable transconductance (gm) pair. In FIG. 10, when the oscillator 900 operates in the high current mode, the gating transistors MG1-MG8 are turned on to provide an additional current, thereby increasing the transconductance (gm) of the transistors within the oscillator 900. On the contrary, In FIG. 11, when the oscillator 900 operates in the low current mode, the gating transistors MG1-MG8 are turned off to save power; meanwhile.

Briefly summarized, in the oscillator of the embodiments, the drain electrodes of the NMOSs and PMOSs are coupled to internal nodes of the inductor, and the gate electrodes of the NMOSs and PMOSs are coupled to the output terminals of the oscillator. Therefore, the inductor may use relative large size to have a small inductance, and the quality factor (Q) will not be degraded due to the small inductance design; and an intrinsic LC-low-pass filter is formed to filter out the unwanted high frequency component. In addition, the output oscillation signals may have higher swing (greater than the supply voltage) to increase the SNR.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. An oscillator (100, 600, 900) for generating oscillation signals at two output terminals (N1, N2), comprising:
an inductor (120, 620) coupled between the two output terminals (N1, N2);
a capacitor (110, 610) coupled between the two output terminals (N1, N2);
two P-type transistors (MP1, MP2), wherein source electrodes of the two P-type transistors (MP1, MP2) are coupled to a supply voltage, and gate electrodes of the two P-type transistors (MP1, MP2) are coupled to the two output terminals (N1, N2), respectively; and
two N-type transistors (MN1, MN2), wherein gate electrodes of the two N-type transistors (MN1, MN2) are coupled to the two output terminals (N1, N2), respectively, and drain electrodes (ND1, ND2) of the two N-type transistors (MN1, MN2) are coupled to drain electrodes (ND1, ND2) of the two P-type transistors (MP1, MP2), respectively;
wherein the drain electrodes (ND1, ND2) of the two N-type transistors (MN1, MN2) are coupled to two internal nodes of the inductor (120, 620);
**characterized in that**
each of the drain electrodes of the two N-type transistors
is directly connected to a respective node of the internal nodes of the inductor, or
is connected via a switch (SW1, SW3) of a switch module (SW1 - SW4) to a respective node of the internal nodes of the inductor, wherein the switch is directly connected to the drain electrode of the respective N-type transistor (MN1, MN2) and the respective internal node of the inductor (620), for selectively connecting the drain electrodes of two N-type transistors (MN1, MN2) to the two internal nodes of the inductor (620) or not,
wherein at least a segment of the inductor is in between the two internal nodes of the inductor (120, 620) and a further segment of the inductor (120, 620) is in between each of the internal nodes and a respective output terminal of the two output terminals (N1, N2).

2. The oscillator (100, 600, 900) of claim 1, **characterized in that** the capacitor (110, 610) and a portion of the inductor ((1-α)^{∗}L) form a low-pass filter (102) for filtering an unwanted frequency component.

3. The oscillator (100, 600, 900) of claim 2, **characterized in that** the unwanted frequency component is generated according to another portion of the inductor (α^{∗}L) and a parasitic capacitance (C_{PAR}).

4. The oscillator (100, 600, 900) of claim 1 when each of the drain electrodes of the two N-type transistors is directly connected to a respective node of the internal nodes of the inductor, **characterized in that** the oscillator (100, 600, 900) further comprises:
a first auxiliary capacitor (510, C_{RES}), coupled between one of the two output terminals (N1) and the drain electrode (ND1) of one of the two N-type transistors (MN1).

5. The oscillator (100, 600, 900) of claim 4, **characterized in that** the capacitor (110, 610), the first auxiliary capacitor (510, C_{RES}) and a portion of the inductor ((1-α)^{∗}L) form a low-pass filter (102) to filter an unwanted frequency component.

6. The oscillator (100, 600, 900) of claim 5, **characterized in that** the unwanted frequency component is generated according to another portion of the inductor (α^{∗}L) and a parasitic capacitance (C_{PAR}).

7. The oscillator (100, 600, 900) of claim 6, **characterized in that** a capacitance of the first auxiliary capacitor (510, C_{RES}) satisfies an equation: α^{∗}L^{∗}C_{PAR}=(1-α)^{∗}L^{∗}C_{RES}, (α^{∗}L) is an inductance of the another portion of the inductor, C_{PAR} is the parasitic capacitance, ((1-α)^{∗}L) is an inductance of the portion of the inductor, and C_{RES} is the capacitance of the first auxiliary capacitor.

8. The oscillator (100, 600, 900) of claim 4, **characterized in that** the oscillator (100, 600, 900) further comprises:
a second auxiliary capacitor (520, C_{RES}), coupled between another one of the two output terminals (N2) and the drain electrode (ND2) of another one of the two N-type transistors (MN2).

9. The oscillator (600) of claim 1, **characterized in that** the switch module (SW1-SW4) further selectively connects the drain electrodes of two N-type transistors (MN1, MN2) to other two internal nodes of the inductor (620) or not.

10. The oscillator (600) of claim 9, **characterized in that** when the oscillator operates (600) in a first mode, the switch module (SW1-SW4) connects the drain electrodes of two N-type transistors (MN1, MN2) to the two internal nodes of the inductor (620), and not connect the drain electrodes of two N-type transistors (MN1, MN2) to the other two internal nodes of the inductor (620); and when the oscillator (600) operates in a second mode, the switch module (SW1-SW4) connects the drain electrodes of two N-type transistors (MN1, MN2) to the other two internal nodes of the inductor (620), and not connect the drain electrodes of two N-type transistors (MN1, MN2) to the two internal nodes of the inductor (620).

11. The oscillator (600) of claim 10, **characterized in that** the first mode is a Long Term Evolution (LTE) mode, and the second mode is a 2G mode.

12. The oscillator (900) of claim 1 when each of the drain electrodes of the two N-type transistors is directly connected to a respective node of the internal nodes of the inductor, **characterized in that** the oscillator (100, 600, 900) further comprises:
a plurality of gating transistors (MG1-MG8) connected in parallel with the two P-type transistors (MP1, MP2) and the two N-type transistors (MN1, MN2), respectively, for providing additional current to adjust a transconductance of the oscillator (900).

13. The oscillator (100) of claim 12, **characterized in that** the oscillator (900) operates in a first mode, the gating transistors (MG1-MG8) are turned off; and when the oscillator (900) operates in a second mode, the gating transistors (MG1-MG8) are turned on.

## Patentansprüche

1. Oszillator (100, 600, 900) zum Generieren von Schwingungssignalen an zwei Ausgangsanschlüssen (N1, N2), aufweisend:
eine Spule (120, 620), die zwischen den zwei Ausgangsanschlüssen (N1, N2) angeschlossen ist;
einen Kondensator (110, 610), der zwischen den zwei Ausgangsanschlüssen (N1, N2) angeschlossen ist;
zwei P-Typ-Transistoren (MP1, MP2), wobei Source-Elektroden der zwei P-Typ-Transistoren (MP1, MP2) mit einer Versorgungsspannung verbunden sind, und Gate-Elektroden der zwei P-Typ-Transistoren (MP1, MP2) jeweils mit den zwei Ausgangsanschlüssen (N1, N2) verbunden sind; und
zwei N-Typ-Transistoren (MN1, MN2), wobei Gate-Elektroden der zwei N-Typ-Transistoren (MN1, MN2) jeweils mit den zwei Ausgangsanschlüssen (N1, N2) verbunden sind, und Drain-Elektroden (ND1, ND2) der zwei N-Typ-Transistoren (MN1, MN2) jeweils mit Drain-Elektroden (ND1, ND2) der zwei P-Typ-Transistoren (MP1, MP2) verbunden sind;
wobei die Drain-Elektroden (ND1, ND2) der zwei N-Typ-Transistoren (MN1, MN2) mit zwei internen Knoten der Spule (120, 620) verbunden sind;
**dadurch gekennzeichnet, dass**
jede der Drain-Elektroden der zwei N-Typ-Transistoren direkt mit einem jeweiligen Knoten der internen Knoten der Spule verbunden ist, oder
über einen Schalter (SW1, SW3) eines Schaltermoduls (SW1-SW4) mit einem jeweiligen Knoten der internen Knoten der Spule verbunden ist, wobei der Schalter direkt mit der Drain-Elektrode des jeweiligen N-Typ-Transistors (MN1, MN2) und dem jeweiligen internen Knoten der Spule (620) verbunden ist, um selektiv die Drain-Elektroden der zwei N-Typ-Transistoren (MN1, MN2) mit den zwei internen Knoten der Spule (620) zu verbinden oder nicht,
wobei mindestens ein Segment der Spule zwischen den zwei internen Knoten der Spule (120, 620) liegt, und ein weiteres Segment der Spule (120, 620) zwischen jedem der internen Knoten und einem jeweiligen Ausgangsanschluss der zwei Ausgangsanschlüsse (N1, N2) liegt.

2. Oszillator (100, 600, 900) gemäß Anspruch 1, **dadurch gekennzeichnet, dass** der Kondensator (110, 610) und ein Teil der Spule ((1-α)^{∗}L) ein Tiefpassfilter (102) zum Filtern einer unerwünschten Frequenzkomponente bilden.

3. Oszillator (100, 600, 900) gemäß Anspruch 2, **dadurch gekennzeichnet, dass** die unerwünschte Frequenzkomponente gemäß einem anderen Teil der Spule (α^{∗}L) und einer parasitären Kapazität (C_{PAR}) generiert wird.

4. Oszillator (100, 600, 900) gemäß Anspruch 1, wenn jede der Drain-Elektroden der zwei N-Typ-Transistoren direkt mit einem jeweiligen Knoten der internen Knoten der Spule verbunden ist, **dadurch gekennzeichnet, dass** der Oszillator (100, 600, 900) weiter aufweist:
einen ersten Zusatzkondensator (510, C_{RES}), der zwischen einem der zwei Ausgangsanschlüsse (N1) und der Drain-Elektrode (ND1) eines der zwei N-Typ-Transistoren (MN1) angeschlossen ist.

5. Oszillator (100, 600, 900) gemäß Anspruch 4, **dadurch gekennzeichnet, dass** der Kondensator (110, 610), der erste Zusatzkondensator (510, C_{RES}) und ein Teil der Spule ((1-α)^{∗}L) ein Tiefpassfilter (102) bilden, um eine unerwünschte Frequenzkomponente zu filtern.

6. Oszillator (100, 600, 900) gemäß Anspruch 5, **dadurch gekennzeichnet, dass** die unerwünschte Frequenzkomponente gemäß einem anderen Teil der Spule (α^{∗}L) und einer parasitären Kapazität (C_{PAR}) generiert wird.

7. Oszillator (100, 600, 900) gemäß Anspruch 6, **dadurch gekennzeichnet, dass** eine Kapazität des ersten Zusatzkondensators (510, C_{RES}) eine Gleichung erfüllt: α^{∗}L^{∗}C_{PAR}=(1-α)^{∗}L^{∗}C_{RES}, (α^{∗}L) eine Induktivität eines anderen Teils der Spule ist, C_{PAR} die parasitäre Kapazität ist, ((1-α)^{∗}L) eine Induktivität des Teils der Spule ist, und C_{RES} die Kapazität des ersten Zusatzkondensators ist.

8. Oszillator (100, 600, 900) gemäß Anspruch 4, **dadurch gekennzeichnet, dass** der Oszillator (100, 600, 900) weiter aufweist:
einen zweiten Zusatzkondensator (520, C_{RES}), der zwischen einem anderen der zwei Ausgangsanschlüsse (N2) und der Drain-Elektrode (ND2) eines anderen der zwei N-Typ-Transistoren (MN2) angeschlossen ist.

9. Oszillator (600) gemäß Anspruch 1, **dadurch gekennzeichnet, dass** das Schaltermodul (SW1-SW4) weiter selektiv die Drain-Elektroden zweier N-Typ-Transistoren (MN1, MN2) mit anderen zwei internen Knoten der Spule (620) verbindet oder nicht.

10. Oszillator (600) gemäß Anspruch 9, **dadurch gekennzeichnet, dass**, wenn der Oszillator (600) in einem ersten Modus arbeitet, das Schaltermodul (SW1-SW4) die Drain-Elektroden zweier N-Typ-Transistoren (MN1, MN2) mit den zwei internen Knoten der Spule (620) verbindet, und die Drain-Elektroden zweier N-Typ-Transistoren (MN1, MN2) nicht mit den anderen zwei internen Knoten der Spule (620) verbindet; und wenn der Oszillator (600) in einem zweiten Modus arbeitet, das Schaltermodul (SW1-SW4) die Drain-Elektroden zweier N-Typ-Transistoren (MN1, MN2) mit den anderen zwei internen Knoten der Spule (620) verbindet, und die Drain-Elektroden zweier N-Typ-Transistoren (MN1, MN2) nicht mit den zwei internen Knoten der Spule (620) verbindet.

11. Oszillator (600) gemäß Anspruch 10, **dadurch gekennzeichnet, dass** der erste Modus ein Long-Term-Evolution- (LTE-) Modus ist und der zweite Modus ein 2G-Modus ist.

12. Oszillator (900) gemäß Anspruch 1, wenn jede der Drain-Elektroden der zwei N-Typ-Transistoren direkt mit einem jeweiligen Knoten der internen Knoten der Spule verbunden ist, **dadurch gekennzeichnet, dass** der Oszillator (100, 600, 900) weiter aufweist:
eine Mehrzahl von Gating-Transistoren (MG1-MG8), die jeweils parallel mit den zwei P-Typ-Transistoren (MP1, MP2) und den zwei N-Typ-Transistoren (MN1, MN2) verbunden sind, zum Bereitstellen eines zusätzlichen Stroms, um eine Transkonduktanz des Oszillators (900) einzustellen.

13. Oszillator (100) gemäß Anspruch 12, **dadurch gekennzeichnet, dass** der Oszillator (900) in einem ersten Modus arbeitet, die Gating-Transistoren (MG1-MG8) abgeschaltet sind; und wenn der Oszillator (900) in einem zweiten Modus arbeitet, die Gating-Transistoren (MG1-MG8) eingeschaltet sind.

## Revendications

1. Oscillateur (100, 600, 900) pour générer des signaux d'oscillation au niveau de deux bornes de sortie (N1, N2), comprenant :
une bobine d'induction (120, 620) couplée entre les deux bornes de sortie (N1, N2) ;
un condensateur (110, 610) couplé entre les deux bornes de sortie (N1, N2) ;
deux transistors de type P (MP1, MP2), où des électrodes de source des deux transistors de type P (MP1, MP2) sont couplées à une tension d'alimentation, et des électrodes de grille des deux transistors de type P (MP1, MP2) sont couplées aux deux bornes de sortie (N1, N2), respectivement ; et
deux transistors de type N (MN1, MN2), où des électrodes de grille des deux transistors de type N (MN1, MN2) sont couplées aux deux bornes de sortie (N1, N2), respectivement, et des électrodes de drain (ND1, ND2) des deux transistors de type N (MN1, MN2) sont couplées à des électrodes de drain (ND1, ND2) des deux transistors de type P (MP1, MP2), respectivement ;
dans lequel
les électrodes de drain (ND1, ND2) des deux transistors de type N (MN1, MN2) sont couplées à deux nœuds internes de la bobine d'induction (120, 620) ;
**caractérisé en ce que**
chacune des électrodes de drain des deux transistors de type N
est directement reliée à un nœud respectif des nœuds internes de la bobine d'induction, ou
est reliée par l'intermédiaire d'un commutateur (SW1, SW3) d'un module de commutation (SW1-SW4) à un nœud respectif des nœuds internes de la bobine d'induction, où le commutateur est directement relié à l'électrode de drain du transistor de type N respectif (MN1, MN2) et au nœud interne respectif de la bobine d'induction (620), pour relier sélectivement les électrodes de drain de deux transistors de type N (MN1, MN2) aux deux nœuds internes de la bobine d'induction(620) ou non,
dans lequel au moins un segment de la bobine d'induction est situé entre les deux nœuds internes de la bobine d'induction (120, 620) et un segment supplémentaire de la bobine d'induction (120, 620) est situé entre chacun des nœuds internes et une borne de sortie respective des deux bornes de sortie (N1, N2).

2. Oscillateur (100, 600, 900) de la revendication 1, **caractérisé en ce que** le condensateur (110, 610) et une partie de la bobine d'induction ((1-α)^{∗}L) forment un filtre passe-bas (102) pour filtrer une composante de fréquence indésirable.

3. Oscillateur (100, 600, 900) de la revendication 2, **caractérisé en ce que** la composante de fréquence indésirable est générée selon une autre partie de la bobine d'induction (α^{∗}L) et une capacité parasite (C_{PAR}).

4. Oscillateur (100, 600, 900) de la revendication 1 lorsque chacune des électrodes de drain des deux transistors de type N est directement reliée à un nœud respectif des nœuds internes de la bobine d'induction, **caractérisé en ce que** l'oscillateur (100, 600, 900) comprend en outre :
un premier condensateur auxiliaire (510, C_{RES}), couplé entre l'une des deux bornes de sortie (N1) et l'électrode de drain (ND1) de l'un des deux transistors de type N (MN1).

5. Oscillateur (100, 600, 900) de la revendication 4, **caractérisé en ce que** le condensateur (110, 610), le premier condensateur auxiliaire (510, C_{RES}) et une partie de la bobine d'induction ((1-α)^{∗}L) forment un filtre passe-bas (102) pour filtrer une composante de fréquence indésirable.

6. Oscillateur (100, 600, 900) de la revendication 5, **caractérisé en ce que** la composante de fréquence indésirable est générée selon une autre partie de la bobine d'induction (α^{∗}L) et une capacité parasite (C_{PAR}).

7. Oscillateur (100, 600, 900) de la revendication 6, **caractérisé en ce qu'**une capacité du premier condensateur auxiliaire (510, C_{RES}) satisfait une équation : α^{∗}L^{∗}C_{PAR} = (1-α)^{∗}L^{∗}C_{RES}, (α^{∗}L) est une inductance de l'autre partie de la bobine d'induction, C_{PAR} est la capacité parasite, ((1-α)^{∗}L) est une inductance de la partie de la bobine d'induction et C_{RES} est la capacité du premier condensateur auxiliaire.

8. Oscillateur (100, 600, 900) de la revendication 4, **caractérisé en ce que** l'oscillateur (100, 600, 900) comprend en outre :
un deuxième condensateur auxiliaire (520, C_{RES}), couplé entre une autre des deux bornes de sortie (N2) et l'électrode de drain (ND2) d'un autre des deux transistors de type N (MN2).

9. Oscillateur (600) de la revendication 1, **caractérisé en ce que** le module de commutation (SW1-SW4) relie en outre sélectivement les électrodes de drain de deux transistors de type N (MN1, MN2) à deux autres nœuds internes de la bobine d'induction (620) ou non.

10. Oscillateur (600) de la revendication 9, **caractérisé en ce que** lorsque l'oscillateur (600) fonctionne dans un premier mode, le module de commutation (SW1-SW4) relie les électrodes de drain de deux transistors de type N (MN1, MN2) aux deux nœuds internes de la bobine d'induction (620), et ne relie pas les électrodes de drain de deux transistors de type N (MN1, MN2) aux deux autres nœuds internes de la bobine d'induction (620) ; et lorsque l'oscillateur (600) fonctionne dans un deuxième mode, le module de commutation (SW1-SW4) relie les électrodes de drain de deux transistors de type N (MN1, MN2) aux deux autres nœuds internes de la bobine d'induction (620), et ne relie pas les électrodes de drain de deux transistors de type N (MN1, MN2) aux deux nœuds internes de la bobine d'induction (620).

11. Oscillateur (600) de la revendication 10, **caractérisé en ce que** le premier mode est un mode d'Évolution à Long Terme (LTE), et le deuxième mode est un mode 2G.

12. Oscillateur (900) de la revendication 1 lorsque chacune des électrodes de drain des deux transistors de type N est directement reliée à un nœud respectif des nœuds internes de la bobine d'induction, **caractérisé en ce que** l'oscillateur (100, 600, 900) comprend en outre :
une pluralité de transistors de déclenchement (MG1-MG8) reliés en parallèle aux deux transistors de type P (MP1, MP2) et aux deux transistors de type N (MN1, MN2), respectivement, pour fournir un courant supplémentaire pour régler une transconductance de l'oscillateur (900).

13. Oscillateur (100) de la revendication 12, **caractérisé en ce que** l'oscillateur (900) fonctionne dans un premier mode, les transistors de déclenchement (MG1-MG8) sont désactivés ; et lorsque l'oscillateur (900) fonctionne dans un deuxième mode, les transistors de déclenchement (MG1-MG8) sont activés.
